# EUROPEAN PATENT SPECIFICATION

(11) **EP 0 915 569 B1**
(45) Date of publication and mention of the grant of the patent: **19.03.2003**
(21) Application number: 98120698.0
(22) Date of filing: 06.11.1998
(51) Int. Cl.: H03L 7/14, H03L 7/10

(54) **Method and apparatus for fast recovery from loss of lock in a phase locked loop**
Verfahren und Vorrichtung zum schnellen Wiedereinschwingen nach einer Unterbrechung in einer PHasenregelschleife
Procédé et dispositif rapides de récupération de synchronisme dans une boucle à verrouillage de phase

(30) Priority: 06.11.1997 US 64666 P
(43) Date of publication of application: 12.05.1999
(73) Proprietor: General Instrument Corporation, Horsham, Pennsylvania 19044 (US)
(72) Inventor: Simon, Harris, Poway, California 92064 (US); Schmidt, Mark S., San Diego, California 92122 (US); Hardy, Fred, San Diego, California 92109 (US); Myatt, Thomas, El Cajon, California 92019 (US)
(74) Representative: Hoeger, Stellrecht & Partner

(56) References cited:
- EP-A- 0 289 941
- EP-A- 0 402 113
- EP-A- 0 664 616
- WO-A-98/23036
- US-A- 4 185 246
- US-A- 4 703 520
- US-A- 4 855 689

## Description

### BACKGROUND OF THE INVENTION

The present invention relates to a method and apparatus for enabling a phase locked loop (PLL) to recover from a loss of lock and for reacquiring a signal to be tracked by the PLL. The invention is useful in any type of communications receiver, including, without limitation, a satellite modem used to receive digital data, digital video, and/or digital audio information.

A satellite modem is a receiver for converting and demodulating a digitally modulated carrier that contains digital data, digital video, and/or digital audio information. The carrier signal is typically QPSK (Quadrature Phase Shift Keying) or OQPSK (Offset Quadrature Phase Shift Keying) modulated. However, the carrier could alternatively be M-ary PSK (Phase Shift Keying) modulated. Other modulation formats may also be used. Although a satellite modem can be provided as a stand alone product, it is more typically found as a component of an integrated receiver decoder (IRD).

The satellite modem receives a signal by acquiring, tracking, synchronizing to, and demodulating the carrier on which the signal is communicated. It then passes the digital video, digital audio, and data down to a digital back end processing section for reconstruction of viewable video and audible audio signals in a conventional manner.

Document D1 = US 4 703 520 discloses a method for recovery of loss of a received carrier according to the preamble of claim 1.

When momentary (e.g., on the order of milliseconds) interruption of the carrier reception occurs, video and audio data become invalid. This can cause video and audio holds that are not provided to a viewer, resulting in unacceptable interruption or gaps in a service (e.g., television program) being watched. For example, when audio data is invalid, the audio output may be muted until the audio becomes valid. Noticeable muting and/or video artifacts will occur if the satellite modem does not reacquire and demodulate the carrier very quickly.

Momentary interruption of carrier reception can be attributed to various causes. Some of the more common causes have been radio frequency (RF) interference from radar and terrestrial conditions, lightning, and power line transients (not to be confused with power brown-outs or black-outs). Since IRD products are installed worldwide, they operate in a variety of environmental conditions which contain some or all of the above mentioned problems. With prior art devices, recovery time from interruptions would sometimes take up to three seconds, with video and audio mutes (blackout) occurring for the duration.

It would be advantageous to provide a method and apparatus for quickly recovering from transient loss of a received carrier. It would be particularly advantageous to provide such a method and apparatus that can successfully recover from transient loss of a carrier received via satellite. The present invention provides a method and apparatus enjoying the aforementioned and other advantages.

### SUMMARY OF THE INVENTION

In order to minimize the recovery time of a receiver (such as a satellite IRD, satellite modem, or the like) to momentary interruptions, the present invention maintains the demodulator control signals in the receiver within a specified window, where a fast reset will allow the receiver to re-acquire and demodulate the signal as quickly as possible (given the receiver is operating within the nominal specified parameters) once the actual cause of the interruption has subsided.

A method in accordance with the invention provides for the rapid recovery from transient loss of a received carrier. A carrier tracking loop having a loop filter is provided. Also provided is a steering loop for maintaining the carrier tracking loop in position for rapid recovery from transient loss of lock. When a transient condition affecting the carrier tracking loop occurs, the transient condition is detected. For example, an abnormally high bit error rate (BER) detected by a forward error correction processor can indicate such a transient condition.

In response to the detection of a transient condition, the loop filter is flushed for a time period dependent upon an anticipated length of the transient condition. For example, it has been determined that the transient effects of lightning typically last for about 5 milliseconds in communication signals. A flush cycle of 20 ms will therefore usually be more than adequate to compensate for a lightning induced transient.

During the flushing step, the loop filter output voltage is forced toward a predetermined reference value (e.g., within a range defined by a "window" having an upper and lower threshold) to minimize any change in frequency of the carrier tracking loop when the loop filter is flushed. As an example, the window can comprise a range of about ± 0.1 volt from a nominal loop filter voltage of about 1 volt. The carrier tracking loop attempts to pull in the frequency and phase of the carrier after the flushing step has been concluded.

Prior to the flushing step during normal carrier operation, the carrier tracking loop operates with a loop bandwidth BW. A steering loop directs the carrier tracking loop in position for rapid recovery without adversely affecting normal tracking operation. In one embodiment, a processor measures the loop filter output voltage while carrier tracking is active and, through separate voltage sources added to the loop filter output voltage, slowly steers the loop filter output voltage to the predetermined reference voltage. The separate voltage sources can be provided by digital to analog converters (DACs). During normal demodulator carrier tracking, slow DAC changes cause corresponding equal and opposite changes to the loop filter output voltage, resulting in the desired steering to the predetermined reference voltage. A transient event will likely force the carrier loop out of lock, driving the loop filter output voltage away from the reference voltage (the normal tracking point) and outside the window of upper and lower thresholds. The flushing returns the loop filter output voltage to the value (or near the value) it was at before the transient event.

After completing the flushing step, the carrier tracking loop is enabled using the loop bandwidth BW. This can be accomplished, for example, by storing the loop bandwidth immediately prior to the flush, and then using the stored value to reinitiate carrier tracking at the same BW after the flush. Alternatively, a reference value can be used to set a nominal loop BW value.

The forward error correction processor can be implemented to initiate resynchronization of the carrier tracking loop with said carrier after carrier tracking and bit timing are lost.

Apparatus is disclosed for recovery from the transient loss of a received carrier. The apparatus includes a carrier tracking loop having a loop filter and a steering loop for the carrier tracking loop. Means are provided for detecting the occurrence of a transient condition affecting the carrier tracking loop. The loop filter is flushed in response to the detecting means for a time period dependent upon an anticipated length of the transient condition. Means are provided for steering a voltage of the loop filter toward a predetermined value during normal tracking and also while the loop filter is being flushed. The steering operation minimizes any change in frequency of the carrier tracking loop during the flushing operation and maximizes the success of carrier tracking recovery. Thereafter, the carrier tracking loop attempts to pull in the frequency and phase of the carrier.

In an illustrated embodiment, apparatus for recovery from transient loss of a received carrier includes a carrier tracking loop having a loop filter and oscillator. A forward error corrector provides an error signal upon the occurrence of a transient condition affecting the carrier tracking loop. A processor is coupled to flush the loop filter in response to the error signal for a time period dependent upon an anticipated length of the transient condition. The processor monitors a voltage of the loop filter, and controls the oscillator in order to maintain the loop filter voltage within a predetermined range while the loop filter is being flushed, thereby minimizing any change in frequency of the carrier tracking loop when the loop filter is flushed. The processor in one embodiment continuously controls the oscillator during the operation of said carrier tracking loop, in order to maintain the loop filter voltage within the predetermined range.

The loop filter can be implemented such that it is responsive to the processor to establish a bandwidth of the carrier tracking loop. Moreover, in such an embodiment the processor can control the loop filter after the filter is flushed to return the bandwidth to a predetermined value.

### BRIEF DESCRIPTION OF THE DRAWINGS

Figure 1 is a block diagram of receiver apparatus incorporating the transient sync loss recovery features of the present invention;
Figure 2 is a graph illustrating the carrier tracking loop (CTL) steering operation during normal (non-transient) operation of the present invention;
Figure 3 is a flowchart of the procedure for steering the CTL to bring the loop filter within limits in accordance with the present invention;
Figure 4 is a flowchart of the procedure for reacquiring a carrier in accordance with the invention; and
Figure 5 is a flowchart of an alternate carrier reacquisition algorithm in accordance with the invention.

### DETAILED DESCRIPTION OF THE INVENTION

The present invention enables a fast recovery from a transient loss of a received carrier. In particular, the carrier tracking loop (CTL) of a receiver is flushed (e.g., zeroed) when a transient loss of carrier lock occurs. The CTL is flushed for a time period which is dependent upon the length of the transient environment. The flushing of the CTL can be accomplished, for example, using a switch, which may be actuated by a microprocessor.

After waiting out the transient, the CTL is enabled using its previous loop bandwidth (i.e., the bandwidth at which the loop was operating before the transient) or at a nominal operating bandwidth and allowed to pull in frequency and phase. After the carrier tracking and bit timing are recovered, a conventional forward error correction (FEC) scheme continues the resynchronization process.

A background process which maintains the CTL loop filter voltage at or near the "loop flush" value performs continuous tracking to minimize the frequency delta (i.e., change in frequency) when the "loop flush" occurs. A key element of the fast recovery method is the assumption that the input receive signal frequency has not changed significantly and remains within the pull-in range of the carrier tracking loop. Although bit timing is potentially lost during the transient, it is assumed that the bit timing loop self acquires after the transient effects have subsided.

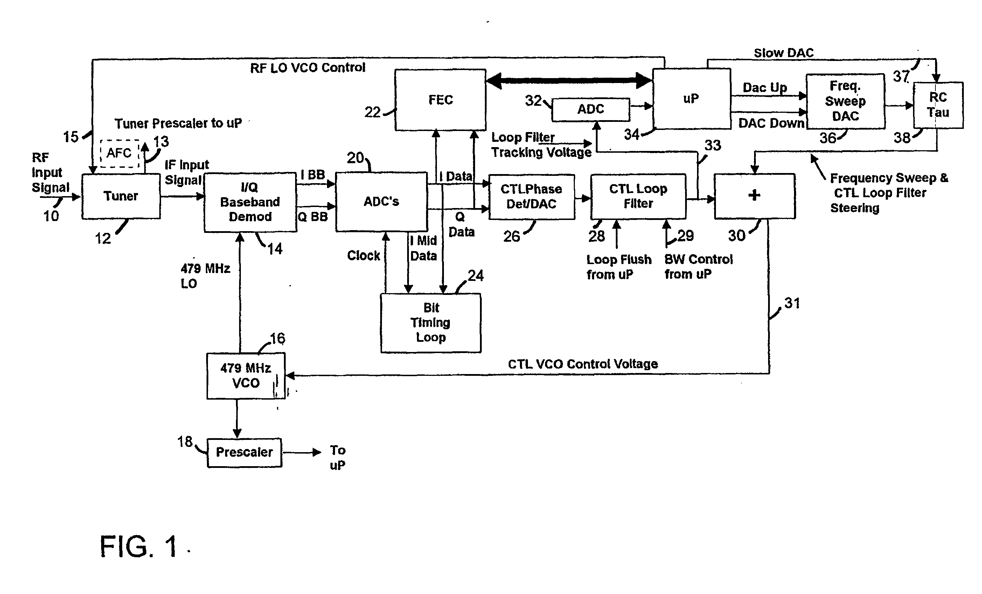

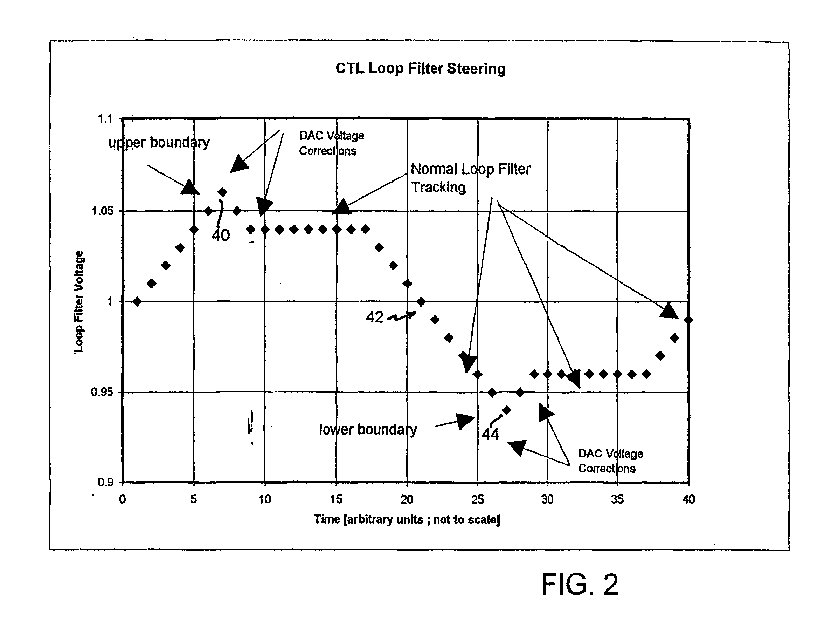

In order for the CTL to be able to pull-in phase and frequency after a loop flush, the frequency offset introduced by the loop flush must be within the loop noise bandwidth. To ensure this condition, real time steering of the CTL tracking loop filter voltage toward the same value of the loop flush voltage must be performed. Figure 1 provides a system block diagram and Figure 2 illustrates the CTL loop filter steering operation during normal demodulator tracking, i.e., when no transient condition is present.

Referring to Figure 1, an input signal 10, such as an RF signal received from a satellite, cable, or other communication channel is coupled to a tuner 12. The tuner selects one of several transmitted signals for further processing, in order to provide a service such as a video program to a user. The tuner frequency is maintained by an automatic frequency control (AFC) loop that comprises a prescaler output 13 and a control signal input 15. The prescaler output 13 is provided to a microprocessor 34, which is responsive thereto for providing the control signal input 15.

Tuner 12 outputs an intermediate frequency (IF) signal in a conventional manner to a demodulator, such as a multiphase I/Q baseband demodulator 14. Multiphase demodulators are well known, for example, in order to demodulate quadrature amplitude modulated (QAM), Quadrature Phase Shift Keying (QPSK) or Offset Quadrature Phase Shift Keying (OQPSK) signals.

As shown in Figure 1, demodulator 14 is responsive to a local oscillator frequency from a voltage controlled oscillator (VCO) 16. A prescaler 18 also receives the VCO output for providing a loop control signal to microprocessor 34. The microprocessor controls the VCO output frequency via a CTL VCO control voltage on line 31.

Demodulator 14 outputs in-phase (I) and quadrature phase (Q) signal components at baseband (i.e., demodulated). The baseband-components are input to analog-to-digital (ADC) converters, which provide corresponding I data and Q data to a carrier tracking loop phase detector and digital-to-analog converter (DAC) 26. The I and Q data is also provided to conventional forward error correction (FEC) circuitry 22. In the specific embodiment shown in Figure 1, which is just one of various possible implementations, a bit timing loop 24 receives the I data as well as I-mid data from ADC's 20. The I-mid data, as well known in the art, represents the midpoint data of the I channel eye pattern.

The CTL phase detector and DAC 26 determines the phase of the I and Q data inputs and converts this information to an analog signal for input to a CTL loop filter 28. The loop filter can comprise, for example, an operational amplifier (op amp) integrator circuit that includes an RC circuit to provide the integration. In accordance with the invention, as described more fully below, the CTL loop filter 28 is flushed upon the occurrence of a transient signal loss in order to enable fast recovery therefrom. A loop flush signal is provided from microprocessor 34 upon the detection of a transient loss condition. The loop flush signal can, for example, be nothing more than a switched ground that grounds the capacitor of the RC integrator circuit provided in the loop filter 28. In such an implementation, the loop flush zeroes the capacitor charge and directs the loop filter output voltage from the supply bias rails to a constant reference voltage at which the loop was previously locked. After the flush, the resistance value of the RC circuit will determine the bandwidth (BW) of the loop. Thus, it is possible to control the loop bandwidth after flushing by providing a control voltage to the RC circuit. Such a control voltage can be set by the microprocessor 34 via a BW control signal 29.

The output of the CTL loop filter 28 comprises a loop filter tracking voltage that is summed in an adder 30 with a frequency sweep and CTL loop filter steering signal from a filter 38. Filter 38 can comprise, for example, a resistor/capacitor (RC) circuit that integrates frequency control signals input thereto. In particular, filter 38 receives frequency sweep signals from a frequency sweep DAC 36 that is responsive to DAC Up and DAC Down commands from the microprocessor 34. The DAC Up and DAC Down commands can provide fine or coarse control of the CTL VCO control voltage conditioned by the filter 38 as necessary, in response to calculations performed by the microprocessor.

The loop filter tracking voltage from CTL loop filter 28 is also provided to an ADC 32, that converts the analog voltage from the loop filter 28 to a corresponding digital data signal which is input to microprocessor 34. The microprocessor determines, from the digital data, whether the magnitude of the loop filter tracking voltage is within a range ("loop flush value window") 42 defined by an upper boundary 40 and a lower boundary 44 shown in Figure 2. If the voltage is outside of the normal loop filter tracking range 42, the microprocessor will control the coarse and/or fine adjustment of the filter 38 in order to slowly drive the loop filter tracking voltage back to a point within the range 42.

The loop filter steering is accomplished outside the CTL using a voltage tracking loop which operates at a much lower bandwidth (relative to the CTL) and operates "small signal" with respect to the CTL. This ensures that the acceleration (loop stress) effects do not cause cycle slips or bit errors in the demodulator. The voltage steering source is the frequency sweep DAC 36, which is also used for frequency sweeping the CTL during acquisition.

The loop filter voltage is measured by the microprocessor 34, which compares it to the calibrated loop flush value window. If the voltage is within the window, no inputs to the frequency sweep DAC 36 are changed. If the voltage is outside the limits, then the frequency sweep DAC is adjusted (at a step size and a rate that does not exceed the CTL tracking dynamics) until the CTL tracking filter voltage is within the assigned limits. The transient recovery method is effective only after the CTL tracking filter voltage reaches the loop flush value (within the assigned window).

Prior art hardware (such as the DigiCipher II system ("DCII") provided by General Instrument Corporation of San Diego, California, USA) could not start this process until after at least 15 seconds of initial carrier lock. This was due to the charge time constant of a "Slow DAC" function used for "loop stress" corrections. The Slow DAC was required to minimize the acceleration input to the CTL so as not to cause cycle slips or bit errors.

In the present invention, a similar Slow DAC function is provided, and once engaged, corrections towards the calibrated target value can be made. In particular, a "Slow DAC" output from the microprocessor 34 via line 37 is provided to provide coarse control during CTL loop tracking. This signal is used to switch the capacitance of filter 38 in order to slow down the DAC output changes during tracking. The object is to steer the CTL loop filter tracking voltage 33 as fast as possible to achieve the target value so that the demodulator can be prepared to undertake the fast reacquisition procedure. The corrections to the DACs can be very fast, e.g., on the order of about 1.0 MHz per second acceleration into the CTL. This assumes approximately a 1.28 MHz frequency control range of the fine DAC control provided by the microprocessor 34 to the frequency sweep DAC 36, using 8 bits of resolution. Such an implementation will provide enhanced recovery for transient activity occurring 20 seconds after initial acquisition and as often as once every 5 seconds thereafter.

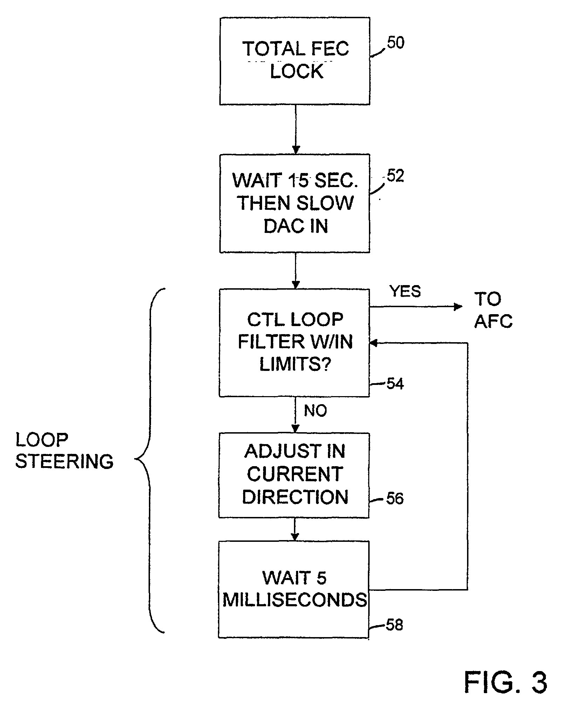

A flowchart of the CTL loop steering process is provided in Figure 3. The process commences at box 50, when the FEC circuitry 22 (Figure 1) detects total FEC lock. Then, assuming that an event such as a channel change may have just occurred, a wait (e.g., 15 seconds) is initiated as indicated at box 52 for the signals to settle out. A coarse adjustment of the filter 38 is then initiated by microprocessor 34 (via the Slow DAC function and/or via the DAC Up and DAC Down control signals), and at box 54 a determination is made as to whether the CTL loop filter output 28 is within the window 42 which represents normal loop filter tracking. If so, the AFC circuit comprising tuner prescaler 13 and control signal 15 are relied on to maintain the correct tuner frequency.

If the CTL loop filter is not within the proper limits, the microprocessor 34 will initiate fine or coarse adjustment of the frequency sweep DAC 36, as necessary, in order to bring the CTL loop filter back within the normal window of operation. This step is indicated at box 56. A short wait (e.g., 5 milliseconds) is provided at box 58, and the CTL loop filter is again tested at box 54 to determine if it is within the proper limits of operation. This process will continue until the CTL loop filter is within the predefined window (i.e., operating with normal tracking as indicated by numeral 42 in Figure 2).

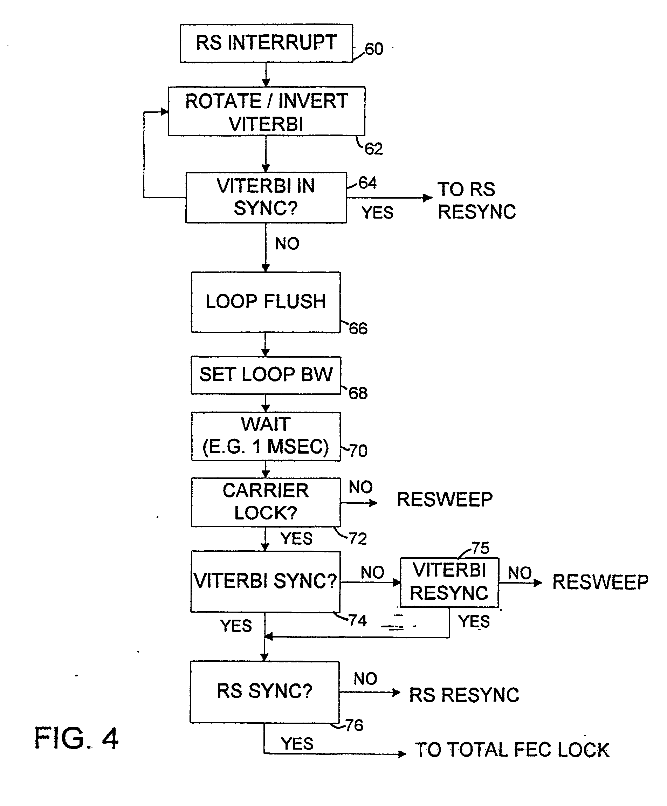

Once the CTL loop filter target value has been achieved, the procedure for fast reacquisition recovery is initiated. This procedure is shown in the flowchart of Figure 4, and commences at box 60 when a Reed-Solomon (RS) interrupt is received. Such a Reed-Solomon interrupt is generated by a conventional coder that uses the well known Reed-Solomon non-binary linear block code to correct symbol errors.

Once a RS interrupt is generated, indicating that the received signal must be reacquired, a trial and error process is commenced in which the conventional Viterbi decoder contained in the digital receiver is adjusted to rotate and invert the Viterbi processing through all possible combinations of the multiphase signal constellation. This process is indicated at box 62. At box 64, a determination is made as to whether resynchronization has been achieved. If so, there is no need to reacquire the signal and control is directed to the RS resynchronization procedure, which resynchronizes the remainder of the FEC. On the other hand, if Viterbi resynchronization is not achieved after several tries via boxes 62 and 64, the CTL loop filter 28 is continuously flushed for a short time, such as 20 milliseconds (or for a variable time if an adaptive control is provided based on different types of transient conditions). The flush duration is set to accommodate the entire expected period of a transient. For example, it has been found that the duration of most transients caused by lightning strikes is less than 20 milliseconds, so a 20 ms flush period will generally be sufficient for such transients. Thus, the continuous loop flush or reset time is selected as a "wait for the storm to pass" time prior to enabling the CTL to reacquire. The loop flush time should be as short as possible, but long enough to let the transient subside. The longer the loop flush time, the more erred bits pass to the digital video pipeline which generates more visible artifacts. The transient recovery time can be a user programmed feature that can be optimized for the type of transient loss of carrier typically experienced at a particular site, whether it be lightning, momentary RF dropouts, momentary RF interference (such as radar), power line induced transients (that cause loss of lock without resetting the IRD), or other phenomena.

After the loop flush, indicated at box 66, the loop bandwidth (BW) is set by microprocessor 34 (via BW control signal 29 shown in Figure 1) to a value that will enable reacquisition. For example, the loop bandwidth can be set to the previous CTL tracking bandwidth (i.e., the last bandwidth at which the CTL was properly tracking the received signal). Once the bandwidth is set, as indicated at box 68, a short wait (e.g., 1 millisecond) is provided at box 70 for carrier acquisition. Then, a determination is made (box 72) as to whether carrier lock has been achieved. If not, the coarse and/or fine DACs are reswept by the microprocessor across an uncertainty range in an attempt to achieve carrier lock.

Once carrier lock is achieved, a determination is made (box 74) as to whether Viterbi synchronization has been achieved. If not, the Viterbi decoder will attempt to resynchronize using its standard algorithm until sync is achieved (box 75). If Viterbi sync cannot be achieved, the CTL loop has not successfully been reacquired. A return to a full frequency sweep ("resweep") is required to achieve carrier lock. Under such circumstances, fast recovery was not achieved.

Once Viterbi synchronization has occurred, a determination is made (box 76) as to whether Reed-Solomon synchronization has been achieved. If not, the RS decoder will attempt to resynchronize in a conventional manner. Upon achieving RS sync, total FEC lock can be pursued in a conventional manner.

Laboratory testing of the described method showed much improved performance over the previous acquisition recovery methods. The test consisted of inserting an interfering CW carrier (10 MHz away from the standard carrier) for a period of 5 milliseconds every 10 seconds. The interference would cause the CTL to drop lock. Recovery was successful more than 90 % of the time and the visible effects were limited to some macroblocking.

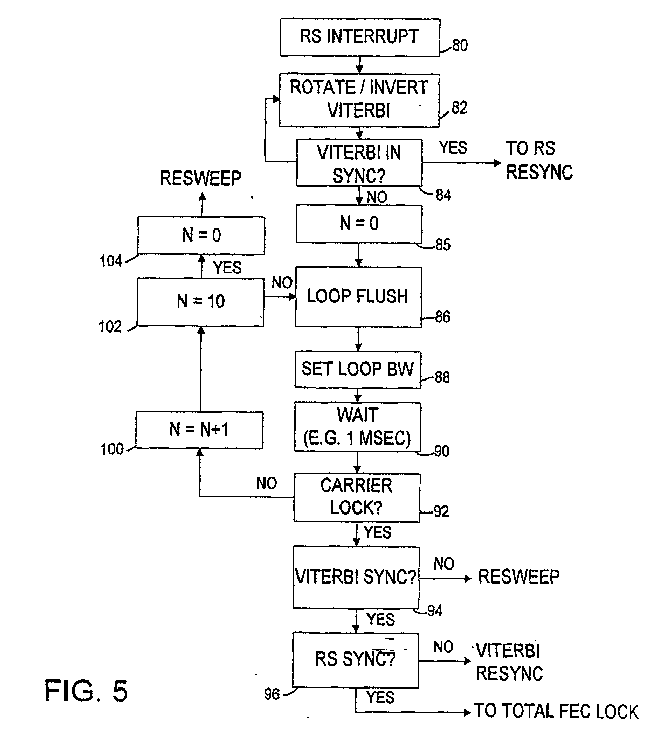

An alternate carrier reacquisition method is illustrated in Figure 5. This method is potentially faster than that shown in Figure 4, has less time for loop flush, and is generally adapted to the transient period.

The CTL loop filter conditions described in connection with Figure 4 have to be satisfied in the embodiment of Figure 5 as well. Boxes 80, 82, 84, 86, 88, 90, 92, 94 and 96 of Figure 5 correspond to boxes 60, 62, 64, 66, 68, 70, 72, 74 and 76 of Figure 4, respectively. However, when the carrier lock is lost, as indicated at box 92, the loop flush is engaged (assuming a count is below a preset value, as indicated at boxes 100, 102, 104) for a shorter time than in the Figure 4 embodiment (e.g., 1 millisecond instead of 20 milliseconds), after which the CTL loop BW is set (box 88) and allowed to acquire for 1 millisecond (box 90). If acquisition does not occur, the process repeats until carrier lock goes true or the event counter reaches the maximum predefined value. Using this method, very short (e.g., 1 millisecond) transients are more quickly recovered from and longer (e.g., 15 millisecond) transients are also recoverable. As indicated at box 85, the counter is reset to zero prior to the first loop flush.

It should now be appreciated that the present invention provides a method and apparatus for fast recovery from a transient loss of a received carrier in a modem, such as a satellite or terrestrial communication modem. The modem includes a carrier tracking loop filter, the voltage of which is steered toward a predetermined value within a "pull-in window" to minimize any change in frequency when the loop is flushed. When a transient occurs, the carrier tracking loop filter is flushed for a time period approximating the length of the transient. Once the transient is over and the flushing step has been completed, the carrier tracking loop is enabled, and attempts to pull in the frequency and phase of the received carrier. This procedure, which maintains the tracking loop within the pull-in window so that the method of "flush" and then "enable" provides quick recovery, has been shown to provide a marked improvement over prior art methods of transient condition recovery. The invention applies to both analog and digitally implemented phase locked loop (PLL) receiver modems.

Although the invention has been described in connection with various preferred embodiments, it will be appreciated that numerous modifications and adaptations may be made thereto without departing from the scope of the invention as set forth in the claims.

## Claims

1. A method for recovery from transient losses of a received carrier, comprising the steps of:
providing a carrier tracking loop having a loop filter;
detecting the occurrence of a transient condition which causes a loss of lock of said carrier tracking loop;
**characterized by**
flushing said loop filter in response to said detecting step for a predetermined time period dependent upon an anticipated length of said transient condition;
forcing a voltage of said loop filter toward a predetermined value during said flushing step to minimize any change in frequency of said carrier tracking loop when said loop filter is flushed; and
enabling said carrier tracking loop to attempt to pull in the frequency and phase of said carrier after said flushing step has been concluded.

2. A method in accordance with claim 1 comprising the further step of:
seeking to maintain the voltage of the loop filter at said predetermined value via a steering loop.

3. A method in accordance with claim 1 or 2, wherein:
said carrier tracking loop operates at a loop bandwidth BW prior to said flushing step, and
after completing said flushing step, the carrier tracking loop is enabled using said loop bandwidth BW.

4. A method in accordance with one of the preceding claims, wherein said detecting step detects said occurrence based on an error signal.

5. A method in accordance with claim 4 wherein said error signal is provided by a forward error correction scheme.

6. A method in accordance with claim 5 wherein said forward error correction scheme initiates resynchronization of said carrier tracking loop with said carrier after carrier tracking and bit timing are lost.

7. A method in accordance with one of the preceding claims, wherein said voltage of said loop filter is continuously forced toward said predetermined valve during said flushing of said loop filter.

8. A method in accordance with any of the preceding claims comprising the step of:
forcing the loop filter to a predetermined loop output voltage via a steering loop associated with said carrier tracking loop.

9. Apparatus for recovery from transient loss of a received carrier, comprising:
a carrier tracking loop having a loop filter;
means for detecting the occurrence of a transient condition which causes a loss of lock of said carrier tracking loop;
**characterized in that**
means for flushing said loop filter in response to said detecting means for a predetermined time period dependent upon an anticipated length of said transient condition are provided;
means for forcing a voltage of said loop filter towards a predetermined value while said loop filter is being flushed to minimize any change in frequency of said carrier tracking loop when said loop filter is flushed are provided; and
means for enabling said carrier tracking loop to attempt to pull in the frequency and phase of said carrier after said loop filter has been flushed are provided.

10. Apparatus in accordance with claim 9 further comprising:
means for slowly steering said voltage of said loop filter within a predetermined range without losing lock during normal tracking operation.

11. Apparatus in accordance with claims 8 or 9 comprising:
an oscillator in said carrier tracking loop;
a forward error corrector, said forward error corrector providing an error signal upon the occurrence of a transient condition affecting said carrier tracking loop; and
a processor coupled to flush said loop filter in response to said error signal for a time period dependent upon an anticipated length of said transient condition;
said processor monitoring said voltage of said loop filter, and controlling said oscillator in order to maintain said voltage of said loop filter within a predetermined range while the loop filter is being flushed, thereby minimizing any change in frequency of said carrier tracking loop when said loop filter is flushed.

12. Apparatus in accordance with claim 11, wherein said processor continuously controls said oscillator during the operation of said carrier tracking loop in order to maintain said voltage of said loop filter within said predetermined range.

13. Apparatus in accordance with claim 11 or 12, wherein:
said loop filter is responsive to said processor to establish a bandwidth of said carrier tracking loop; and
said processor controls said voltage of said loop filter after the filter is flushed to return the bandwidth to a predetermined value.

14. Apparatus in accordance with any of claims 11 to 13 comprising:
an oscillator in said carrier tracking loop having
a steering loop associated with said carrier tracking loop to force the loop filter to a predetermined loop output voltage value.

15. Apparatus in accordance with claim 8 or 9 further comprising:
a forward error corrector, said forward error corrector providing an error signal upon the occurrence of a transient condition affecting said carrier tracking loop; and
a processor coupled to flush said loop filter in response to said error signal for a time period dependent upon an anticipated length of said transient condition;
said processor monitoring said voltage of said loop filter, and controlling said oscillator i n order to force said voltage of said loop filter to said predetermined loop output voltage value while the loop filter is being flushed, thereby minimizing any change in frequency of said carrier tracking loop when said loop filter is flushed.

## Patentansprüche

1. Ein Verfahren zur Wiederherstellung nach Übergangsverlusten eines Empfangsträgers, bestehend aus folgenden Schritten:
Bereitstellen einer Trägerabtastschleife mit einem Schleifenfilter;
Ermitteln des Auftretens eines Übergangszustands, der einen Aufschaltungsausfall der Trägerabtastschleife bewirkt;
**gekennzeichnet durch**
Säubern des Schleifenfilters als Reaktion auf den Ermittlungsschritt für eine festgelegte Zeitspanne in Abhängigkeit von der voraussichtlichen Dauer des Übergangszustands;
Zwingen einer Spannung des Schleifenfilters in Richtung eines festgelegten Wertes während des Säuberungsschritts, um jede Frequenzänderung der Trägerabtastschleife zu minimieren, wenn der Schleifenfilter gesäubert wird; und
Freigeben der Trägerabtastschleife, um zu versuchen, die Frequenz und die Phase des Trägers, nachdem der Säuberungsschritt beendet wurde, einzuschwingen.

2. Verfahren gemäß Anspruch 1, bestehend aus dem weiteren Schritt:
Versuchen, durch eine Steuerschleife die Spannung des Schleifenfilters auf dem festgelegten Wert zu halten.

3. Verfahren gemäß Anspruch 1 oder 2, wobei:
die Trägerschleife vor dem Säuberungsschritt auf einer Schleifenbandbreite BW arbeitet, und
die Trägerabtastschleife nach Ausführung des Säuberungschrittes freigegeben wird, wobei die Schleifenbandbreite BW verwendet wird.

4. Verfahren gemäß einem der vorhergehenden Ansprüche, wobei der Ermittlungsschritt das Auftreten auf einem Fehlersignal basierend ermittelt.

5. Verfahren gemäß Anspruch 4, wobei das Fehlersignal durch ein Vorwärtsfehlerkorrekturschema bereitgestellt wird.

6. Verfahren gemäß Anspruch 5, wobei das Vorwärtsfehlerkorrekturschema die Resynchronisation der Trägerabtastschleife mit dem Träger einleitet, nachdem das Trägerabtasten und der Bittakt unterbrochen sind.

7. Verfahren gemäß einem der vorhergehenden Ansprüche, wobei die Spannung des Schleifenfilters während des Säuberns des Schleifenfilters kontinuierlich in Richtung des festgelegten Wertes gezwungen wird.

8. Verfahren gemäß einem der vorhergehenden Ansprüche, bestehend aus folgendem Schritt:
Zwingen des Schleifenfilters in Richtung einer festgelegten Schleifenausgangsspannung durch eine mit der Trägerabtastschleife verbundene Steuerschleife.

9. Eine Vorrichtung zur Wiederherstellung nach Übergangsverlust eines Empfangsträgers, bestehend aus:
einer Trägerabtastschleife mit einem Schleifenfilter;
Mitteln zum Ermitteln des Auftretens eines Übergangszustands, der einen Aufschaltungsausfall der Trägerabtastschleife bewirkt;
**dadurch gekennzeichnet, dass**
Mittel zum Säubern des Schleifenfilters als Reaktion auf das Ermittlungsmittel für eine festgelegte Zeitspanne in Abhängigkeit von der voraussichtlichen Dauer des Übergangszustands bereitgestellt sind;
Mittel zum Zwingen einer Spannung des Schleifenfilters in Richtung eines festgelegten Wertes, während der Schleifenfilter gesäubert wird, um jede Frequenzänderung der Trägerabtastschleife zu minimieren, wenn der Schleifenfilter gesäubert wird, bereitgestellt sind; und
Mittel zur Freigabe der Trägerabtastschleife, um zu versuchen, die Frequenz und die Phase des Trägers einzuschwingen, nachdem der Schleifenfilter gesäubert wurde, bereitgestellt sind.

10. Vorrichtung gemäß Anspruch 9, ferner bestehend aus:
Mitteln zum langsamen Steuern der Spannung des Schleifenfilters innerhalb eines festgelegten Bereichs ohne Aufschaltungsausfall während des normalen Abtastvorgangs.

11. Vorrichtung gemäß Anspruch 8 oder 9, bestehend aus:
einem Oszillator in der Trägerabtastschleife;
einem Vorwärtsfehlerkorrektor, wobei der Vorwärtsfehlerkorrektor ein Fehlersignal beim Auftreten eines Übergangszustands, der die Trägerabtastschleife beeinträchtigt, bereitstellt; und
einem Prozessor, der gekoppelt ist, um den Schleifenfilter als Reaktion auf das Fehlersignal für eine festgelegte Zeitspanne in Abhängigkeit von der voraussichtlichen Dauer des Übergangszustands zu säubern;
wobei der Prozessor die Spannung des Schleifenfilters überwacht und den Oszillator kontrolliert, um die Spannung des Schleifenfilters innerhalb eines festgelegten Bereichs zu halten, während der Schleifenfilter gesäubert wird, wodurch jede Frequenzänderung der Trägerabtastschleife minimiert wird, wenn der Schleifenfilter gesäubert wird.

12. Vorrichtung gemäß Anspruch 11, wobei der Prozessor während des Betriebs der Trägerabtastschleife kontinuierlich den Oszillator kontrolliert, um die Spannung des Schleifenfilters innerhalb des festgelegten Bereichs zu halten.

13. Vorrichtung gemäß Anspruch 11 oder 12, wobei:
der Schleifenfilter auf den Prozessor reagiert, um eine Bandbreite der Trägerabtastschleife aufzubauen; und
der Prozessor die Spannung des Schleifenfilters kontrolliert, nachdem der Schleifenfilter gesäubert wurde, um die Bandbreite auf einen festgelegten Wert zurückzubringen.

14. Vorrichtung gemäß einem der Ansprüche 11 bis 13, bestehend aus:
einem Oszillator in der Trägerabtastschleife mit
einer Steuerschleife, die mit der Trägerabtastschleife verbunden ist, um den Schleifenfilter in Richtung eines festgelegten Schleifenausgangsspannungswertes zu zwingen.

15. Vorrichtung gemäß Anspruch 8 oder 9, ferner bestehend aus:
einem Vorwärtsfehlerkorrektor, wobei der Vorwärtsfehlerkorrektor ein Fehlersignal beim Auftreten eines Übergangszustands, der die Trägerabtastschleife beeinträchtigt, bereitstellt; und
einem Prozessor, der gekoppelt ist, um den Schleifenfilter als Reaktion auf das Fehlersignal für eine festgelegte Zeitspanne in Abhängigkeit von der voraussichtlichen Dauer des Übergangszustands zu säubern;
wobei der Prozessor die Spannung des Schleifenfilters überwacht und den Oszillator kontrolliert, um die Schleifenfilterspannung auf den festgelegten Schleifenausgangsspannungswert zu zwingen, während der Schleifenfilter gesäubert wird, wodurch jede Frequenzänderung der Trägerabtastschleife minimiert wird, wenn der Schleifenfilter gesäuber wird.

## Revendications

1. Un procédé de récupération de pertes transitoires d'une onde porteuse reçue, comprenant les étapes consistant :
à fournir une boucle de suivi d'onde porteuse ayant un filtre de boucle ;
à détecter l'apparition d'un état transitoire qui provoque une perte de verrouillage de ladite boucle de suivi d'onde porteuse ;
**caractérisé par** le fait
de purger ledit filtre de boucle en réponse à ladite étape de détection pendant un laps de temps prédéterminé en fonction d'une durée anticipée dudit état transitoire ;
de contraindre une tension dudit filtre de boucle à s'approcher d'une valeur prédéterminée durant ladite étape de purge pour minimiser tout changement dans la fréquence de ladite boucle de suivi d'onde porteuse lorsque ledit filtre de boucle est purgé ; et
d'autoriser ladite boucle de suivi d'onde porteuse à tenter de relever la fréquence et la phase de ladite onde porteuse après que ladite étape de purge a été achevée.

2. Un procédé conformément à la revendication 1 comprenant l'étape supplémentaire consistant :
à chercher à maintenir la tension du filtre de boucle à ladite valeur prédéterminée par l'intermédiaire d'une boucle de réglage.

3. Un procédé conformément à la revendication 1 ou la revendication 2, dans lequel :
ladite boucle de suivi d'onde porteuse opère à une largeur de bande de boucle BW avant ladite étape de purge, et
une fois ladite étape de purge achevée, la boucle de suivi d'onde porteuse est validée à l'aide de ladite largeur de bande de boucle BW.

4. Un procédé conformément à l'une des revendications précédentes, dans lequel ladite étape de détection détecte ladite apparition sur la base d'un signal d'erreur.

5. Un procédé conformément à la revendication 4 dans lequel ledit signal d'erreur est fourni par un schéma de correction d'erreur sans voie de retour.

6. Un procédé conformément à la revendication 5 dans lequel ledit schéma de correction d'erreur sans voie de retour déclenche la resynchronisation de ladite boucle de suivi d'onde porteuse avec ladite onde porteuse après la perte du suivi d'onde porteuse et de la synchronisation des bits.

7. Un procédé conformément à l'une des revendications précédentes, dans lequel ladite tension dudit filtre de boucle est contrainte de façon continue à s'approcher de ladite valeur prédéterminés durant ladite purge dudit filtre de boucle.

8. Un procédé conformément à n'importe lesquelles des revendications précédentes comprenant l'étape consistant :
à contraindre le filtre de boucle à adopter une tension de sortie de boucle prédéterminée par l'intermédiaire d'une boucle de réglage associée à ladite boucle de suivi d'onde porteuse.

9. Appareil de récupération de perte transitoire d'une onde porteuse reçue, comprenant :
une boucle de suivi d'onde porteuse ayant un filtre de boucle ;
des moyens destinés à détecter l'apparition d'un état transitoire qui provoque une perte de verrouillage de ladite boucle de suivi d'onde porteuse ;
**caractérisé en ce que**
des moyens sont fournis pour purger ledit filtre de boucle en réponse auxdits moyens de détection pendant un laps de temps prédéterminé en fonction d'une durée anticipée dudit état transitoire ;
des moyens sont fournis pour contraindre une tension dudit filtre de boucle à s'approcher d'une valeur prédéterminée tandis que ledit filtre de boucle est purgé pour minimiser tout changement dans la fréquence de ladite boucle de suivi d'onde porteuse lorsque ledit filtre de boucle est purgé ; et
des moyens sont fournis pour autoriser ladite boucle de suivi d'onde porteuse à tenter de relever la fréquence et la phase de ladite onde porteuse après que ledit filtre de boucle a été purgé.

10. Appareil conformément à la revendication 9 comprenant de plus :
des moyens destinés'à régrer lentement ladite tension dudit filtre de boucle au sein d'une gamme prédéterminée sans perdre de verrouillage durant l'opération de suivi normale.

11. Appareil conformément à la revendication 8 ou la revendication 9 comprenant :
un oscillateur dans ladite boucle de suivi d'onde porteuse ;
un correcteur d'erreur sans voie de retour, ledit correcteur d'erreur sans voie de retour fournissant un signal d'erreur à l'apparition d'un état transitoire affectant ladite boucle de suivi d'onde porteuse ; et
un processeur couplé pour purger ledit filtre de boucle en réponse audit signal d'erreur pendant un laps de temps en fonction d'une durée anticipée dudit état transitoire ;
ledit processeur contrôlant ladite tension dudit filtre de boucle et commandant ledit oscillateur afin de maintenir ladite tension dudit filtre de boucle au sein d'une gamme prédéterminée tandis que le filtre de boucle est purgé, minimisant de ce fait tout changement dans la fréquence de ladite boucle de suivi d'onde porteuse lorsque ledit filtre de boucle est purgé.

12. Appareil conformément à la revendication 11, dans lequel ledit processeur commande de façon continue ledit oscillateur durant l'opération de ladite boucle de suivi d'onde porteuse afin de maintenir ladite tension dudit filtre de boucle au sein de ladite gamme prédéterminée.

13. Appareil conformément à la revendication 11 ou la revendication 12, dans lequel :
ledit filtre de boucle est sensible audit processeur afin d'établir une largeur de bande de ladite boucle de suivi d'onde porteuse ; et
ledit processeur commande ladite tension dudit filtre de boucle après que le filtre a été purgé pour renvoyer la largeur de bande à une valeur prédéterminée.

14. Appareil conformément à n'importe lesquelles des revendications 11 à 13 comprenant :
un oscillateur dans ladite boucle de suivi d'onde porteuse ayant
une boucle de réglage associée avec ladite boucle de suivi d'onde porteuse pour contraindre le filtre de boucle à adopter une valeur de tension de sortie de boucle prédéterminée.

15. Appareil conformément à la revendication 8 ou à la revendication 9 comprenant de plus :
un correcteur d'erreur sans voie de retour, ledit correcteur d'erreur sans voie de retour fournissant un signal d'erreur à l'apparition d'un état transitoire affectant ladite boucle de suivi d'onde porteuse ; et
un processeur couplé pour purger ledit filtre de boucle en réponse audit signal d'erreur pendant un laps de temps en fonction d'une durée anticipée dudit état transitoire ;
ledit processeur contrôlent ladite tension dudit filtre de boucle et commandant ledit oscillateur afin de contraindre ladite tension
dudit filtre de boucle 5 adopter ladite valeur de tension de sortie de boucle prédéterminés tandis que le filtre de boucle est purgé, minimisant de ce fait tout changement dans la fréquence de ladite boucle de suivi d'onde porteuse lorsque ledit filtre de boucle est purgé.
